(19) **Europäisches Patentamt / European Patent Office / Office européen des brevets**

(11) **EP 3 185 029 A1**

(12) # EUROPEAN PATENT APPLICATION

(43) Date of publication:
28.06.2017 Bulletin 2017/26

(51) Int Cl.:
*G01R 33/48* (2006.01)         *G01R 33/561* (2006.01)
*G01R 33/565* (2006.01)

(21) Application number: 15201917.0

(22) Date of filing: 22.12.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Koninklijke Philips N.V.**
**5656 AE Eindhoven (NL)**

(72) Inventor: **Fuderer, Miha**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **MR IMAGING USING PROPELLER ACQUISITION WITH T2 DECAY CORRECTION**

(57) The invention relates to a method of MR imaging of an object (10) placed in an examination volume of a MR device (1). It is an object of the invention to enable PROPELLER imaging using fast spin echo acquisition with a defined $T_2$ contrast. The method of the invention comprises the steps of:
- subjecting the object (10) to a number of shots of a multi-echo imaging sequence, a train of echo signals being generated by each shot,
- acquiring the echo signals, each echo signal representing a k-space profile (31), wherein the echo signals are acquired two or more times for each k-space profile, each time at a different echo time;
- deriving synthesized k-space profiles from the acquired k-space profiles (31), wherein the synthesized k-space profiles are computed for a given target echo time by extrapolating or interpolating the echo signals acquired at the different echo times; and
- reconstructing a MR image from the synthesized k-space profiles. Moreover, the invention relates to a MR device for carrying out this method as well as to a computer program to be run on a MR device.

Fig. 2

EP 3 185 029 A1

**Description**

FIELD OF THE INVENTION

The invention relates to the field of magnetic resonance (MR) imaging. It concerns a method of MR imaging of an object. The invention also relates to a MR device and to a computer program to be run on a MR device.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

According to the MR method in general, the object, for example the body of the patient to be examined, is arranged in a strong, uniform magnetic field whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant $T_1$ (spin lattice or longitudinal relaxation time), and the magnetization in the direction perpendicular to the z direction relaxes with a second time constant $T_2$ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

To realize spatial resolution in the body, constant magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to a MR image by means of an image reconstruction algorithm.

The fast spin echo (FSE) sequence (also termed 'Turbo Spin Echo' - TSE) is a well-known type of a multi-echo imaging sequence which is becoming increasingly popular in MR imaging. One "shot" of the FSE sequence comprises an initial RF pulse for excitation of magnetic resonance followed by a plurality of rapidly applied (typically 180°) refocusing RF pulses generating a train of differently phase-encoded spin echo signals. The echo signals are acquired, wherein each echo signal represents a k-space profile, i.e. a one-dimensional sample of k-space, the position of the k-space profile in k-space being determined by the applied frequency encoding and phase encoding switched magnetic field gradients of the sequence. Typically, a plurality of shots of the multi-echo sequence is applied for completely sampling k-space in order to be able to reconstruct a MR image from the acquired k-space profiles.

In a variety of MRI applications, motion of the examined patient can adversely affect image quality. Acquisition of sufficient MR signals for reconstruction of an image takes a finite period of time. Motion of the patient during that finite acquisition time typically results in motion artifacts in the reconstructed MR image. In conventional MR imaging approaches, the acquisition time can be reduced to a very small extent only, when a given resolution of the MR image is specified. In the case of medical MR imaging, motion artifacts can result for example from cardiac and respiratory cyclic motion, and other physiological processes, as well as from patient motion resulting in blurring, misregistration, deformation and ghosting artifacts.

Different approaches have been developed to overcome problems with respect to motion in MR imaging. Among these is the so-called PROPELLER imaging technique. In the PROPELLER concept (Periodically Rotated Overlapping ParalEL Lines, see James G. Pipe: "Motion Correction With PROPELLER MRI: Application to Head Motion and Free-Breathing Cardiac Imaging", Magnetic Resonance in Medicine, vol. 42, 1999, pages 963-969), MR signal data are acquired in k-space in $N$ strips, each consisting of $L$ parallel k-space lines, corresponding to the $L$ lowest frequency phase-encoding lines in a Cartesian-based k-space sampling scheme. Each strip, which is also referred to as k-space blade, is rotated in k-space by an angle of, for example, 180°/$N$, so that the total MR data set spans a circle in k-space. If a full k-space data matrix having a diameter $M$ is desired, then $L$ and $N$ may be chosen so that $L \times N = M \times \pi/2$. One essential characteristic of PROPELLER is that a central circular portion in k-space, having a diameter $L$, is acquired for each k-space blade. This central portion can be used to reconstruct a low-resolution MR image for each k-space blade. The low-resolution MR images are compared to each other to remove in-plane displacements and phase errors, which are due to patient motion. These factors are corrected for in each k-space blade in accordance with the PROPELLER scheme. A suitable technique such as cross-correlation is employed to determine which k-space blades were acquired with significant through-plane displacement or include other types of artifacts. As the MR signal data are combined in k-space before the reconstruction of the final MR image, the MR data from k-space blades are weighted according to the artifact level detected by cross-correlating the k-space blades, so that artifacts are reduced in the final MR image. The PROPELLER technique makes use of oversampling in the central portion of k-space in order to obtain an MR image acquisition technique that is robust with respect to motion of the examined patient during MR signal acquisition. Moreover, due to the weighted averaging of k-space blades PROPELLER "averages out" further imaging artifacts resulting from, for example, Bo inhomogeneities or inaccurate coil sensitivity maps when parallel imaging techniques like SENSE are used for MR data acquisition.

FSE-type imaging sequences can be used in combination with PROPELLER acquisition for correcting motion between the shots of the respective sequence. Each echo signal of the train of echo signals generated by a shot of the sequence represents a k-space profile. The set of k-space profiles acquired in each shot constitutes a k-space blade of the PROPELLER acquisition.

One inherent problem with FSE imaging is the non-uniformity in the acquired echo signal data arising from $T_2$ decay. The reason for this non-uniformity is the delay (and hence $T_2$ decay) between the first and the last k-space profile acquired in a single shot. $T_2$ decay is more rapid at high-field strengths due to higher susceptibility-induced losses. Thus, signal decay between consecutive echo signals is more prominent. In Cartesian FSE acquisitions, the $T_2$ decay causes image blurring and ghosting, which is seen along the phase-encoding direction. Due to the special signal acquisition scheme in PROPELLER the fact that each k-space profile has its own echo time results in a k-space sampling with non-uniform $T_2$-weighting along the width of each blade. The resulting artifacts are more complex and more difficult to correct than with Cartesian sampling. If a MR image is required with low $T_2$-weighting, the imaging sequence is typically programmed such that the early echoes of each shot sample the center and the late echoes sample the periphery along the width of each k-space blade. However, due to the characteristics of the PROPELLER scheme, it cannot be avoided that each k-space profile comes close to the k-space center. The result is that the contrast in the resulting MR image essentially corresponds to the average echo time of all the k-space profiles. This will typically result in more $T_2$-weighting than actually desired, and the MR image has not the correct contrast.

SUMMARY OF THE INVENTION

From the foregoing it is readily appreciated that there is a need for an improved MR imaging technique. It is consequently an object of the invention to enable fast spin echo acquisition with a better defined $T_2$ contrast.

In accordance with the invention, a method of MR imaging of an object placed in an examination volume of a MR device is disclosed. The method comprises the steps of:

- subjecting the object to a number of shots of a multi-echo imaging sequence, a train of echo signals being generated by each shot,
- acquiring the echo signals, each echo signal representing a k-space profile, wherein the echo signals are acquired two or more times for each k-space profile, each time at a different echo time;
- deriving synthesized k-space profiles from the acquired k-space profiles, wherein the synthesized k-space profiles are computed for a given target echo time by extrapolating or interpolating the echo signals acquired at the different echo times; and

- reconstructing a MR image from the synthesized k-space profiles.

In other words, each k-space profile is scanned at least twice according to the invention. The two scans differ by the echo time. From these two scans, for each k-space profile, a "synthetic" k-space profile is computed for a given target echo time (meaning an echo time value pre-defined by a user according to the desired $T_2$ contrast) by interpolating or extrapolating the two scanned echo signals of the respective k-space profile. This results in a set of synthesized k-space profiles corresponding to the acquired k-space profiles. The difference is that all k-space profiles of the set of synthesized k-space profiles have the same echo time, namely the target echo time. Hence, the $T_2$-weighting within the set of synthesized k-space profiles is more uniform than in the acquired k-space profiles. The contrast in the MR image reconstructed from the synthesized k-space profiles corresponds (at least approximately) to the desired echo time (the target echo time) such that the $T_2$ contrast is better defined than in the prior art approaches, and $T_2$ decay-induced artefacts are reduced.

Preferably, the k-space profiles are acquired as a plurality of k-space subsets, each k-space subset covering a different portion of k-space. According to the invention, the acquired k-space subsets are transformed into synthesized k-space subsets (formed by the corresponding synthesized k-space profiles). The MR image is then reconstructed from a combination of the synthesized k-space subsets.

Preferably, at least a part of a central portion of k-space is covered by each k-space subset. Motion-induced displacements and/or phase errors may be estimated and corrected in the k-space subsets or in the synthesized k-space subsets prior to reconstructing the MR image, like in conventional PROPELLER imaging.

Each k-space subset preferably comprises a number of substantially parallel k-space profiles, wherein the k-space subsets are rotated about the center of k-space, so that the total acquired set of echo signals spans a circle in k-space, wherein a common central circular region of k-space is covered by all k-space subsets. This corresponds to the PROPELLER scheme, wherein each k-subset forms a k-space blade. Each k-space blade may be acquired in a single shot of the multi-echo imaging sequence. This implies that each k-space blade is scanned two or more times within each single shot of the multi-echo imaging sequence, such that each k-space profile is acquired at two or more different echo times according to the invention. In this case, motion of the object can be detected (and correspondingly corrected for) between the shots.

According to a preferred embodiment of the invention, the multi-echo imaging sequence of the invention is a fast spin echo sequence comprising

- at least one RF pulse for excitation of magnetic resonance,
- a plurality of refocusing RF pulses,
- a plurality of switched magnetic field gradients for frequency-encoding of each echo signal, and
- a plurality of switched magnetic field gradients for phase-encoding of each echo signal. In other words, the method of the invention may be applied in combination with known FSE sequences.

The method of the invention described thus far can be carried out by means of a MR device including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Figure 1 shows a MR device for carrying out the method of the invention;
Figure 2 shows a diagram of k-space schematically illustrating the PROPELLER acquisition scheme of the invention.

DETAILED DESCRIPTION OF THE EMBODIMENTS

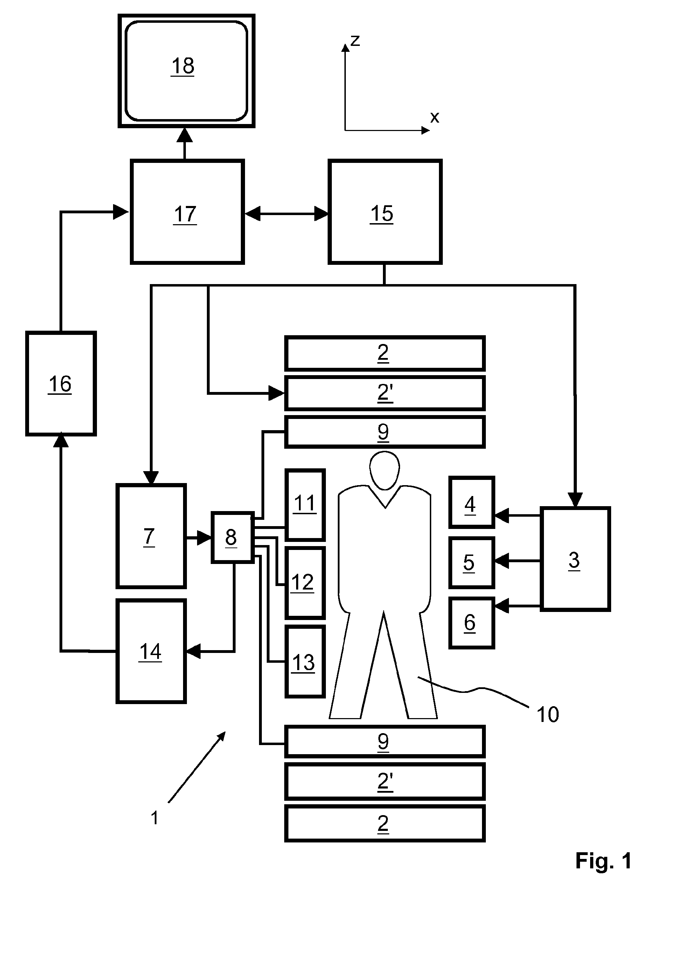

With reference to Figure 1, a MR device 1 is shown. The device comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as fast spin echo (FSE) imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

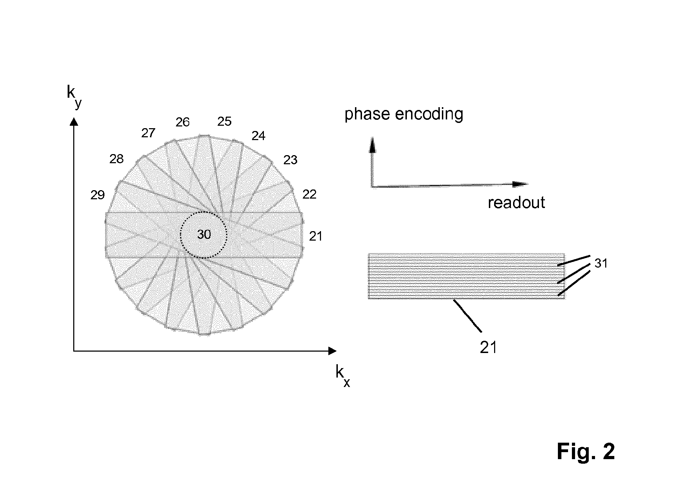

With continuing reference to Figure 1 and with further reference to Figure 2, an embodiment of the imaging approach of the invention is explained in the following.

Figure 2 illustrates the k-space sampling of PROPELLER MR imaging according to the invention.

The body 10 is subjected to multiple shots of a multi-echo imaging sequence. The imaging sequence is a FSE sequence. As shown in the left illustration of Figure 2, nine k-space subsets (blades) 21-29 are acquired. Each blade 21-29 is acquired in a single shot of the FSE sequence and covers a different portion of k-space, wherein a central circular portion 30 of k-space is acquired for each blade 21-29. The blades 21-29 are rotated about the center of k-space, so that the total acquired MR data set spans a circle in k-space. In the right illustration of Figure 2, a single k-space blade 21 is shown. Each of the blades 21-29 is constituted by a number of parallel k-space profiles 31. The orientation of the phase encoding direction and the readout direction relative to the blade orientation is maintained for all rotation angles of the k-space blades 21-29. Motion-induced displacements and/or phase errors are estimated and corrected in the k-space subsets like in conventional PROPELLER imaging.

Each k-space profile 31 is scanned at least twice according to the invention. For example, each blade 21-29 maybe constituted by 20 k-space profiles, numbered from -10 to +9 in the phase encoding direction. The time interval between the individual echoes generated by each shot of the FSE sequence may be 2 ms. During a first scan of each blade 21-29 the following echo times $TE_i$ (i indicating the profile number) are obtained: $TE_{-10}$ = 2 ms, $TE_{-9}$ = 4 ms, ..., $TE_{+9}$ = 40 ms; during a second scan, the corresponding echo times are 42 ms, 44 ms, ..., 80 ms. So each k-space profile 31 is acquired at two different echo times $TE_{i,1}$ and $TE_{i,2}$ (for profile number +3, these would be $TE_{+3,1}$ = 26 ms and $TE_{+3,2}$ = 66 ms, for example). The corresponding echo signals are $S_{i,1}(k_x)$ and $S_{i,2}(k_x)$, wherein $k_x$ stands for the k-space coordinate in the readout direction.

A user of the MR device 1 chooses a "target echo time" $TE_T$ (for example 40 ms). By assuming (as an approximation) a linear $T_2$ decay, synthesized k-space profiles $S_{S,i}(k_x)$ are computed for the target echo time according to:

$$S_{S,i}(k_x) = S_{i,1}(k_x) + \frac{S_{i,2}(k_x) - S_{i,1}(k_x)}{TE_{i,2} - TE_{i,1}}(TE_T - TE_{i,1}).$$

This is performed for each blade 21-29 to obtain a set of synthesized k-space subsets, wherein the $T_2$-weighting within each synthesized k-space subset is uniform and corresponds to the target echo time $TE_T$. A MR image is reconstructed from the synthesized k-space subsets. The contrast in the reconstructed MR image corresponds (at least approximately) to the target echo time $TE_T$. The derivation of the synthesized k-space subsets and the reconstruction of the MR image may be repeated for a number of different target echo times $TE_T$ in order to obtain a corresponding number of differently $T_2$-weighted MR images without the need of additional MR signal acquisition steps.

**Claims**

1. Method of MR imaging of an object (10) placed in an examination volume of a MR device (1), the method comprising the steps of:

   - subjecting the object (10) to a number of shots of a multi-echo imaging sequence, a train of echo signals being generated by each shot,
   - acquiring the echo signals, each echo signal representing a k-space profile (31), wherein the echo signals are acquired two or more times for each k-space profile (31), each time at a different echo time;
   - deriving synthesized k-space profiles from the acquired k-space profiles (31), wherein the synthesized k-space profiles are computed for a given target echo time by extrapolating or interpolating the echo signals acquired at the different echo times; and
   - reconstructing a MR image from the synthesized k-space profiles.

2. Method of claim 1, wherein the k-space profiles (31) are acquired as a plurality of k-space subsets (21-29), each k-space subset (21-29) covering a different portion of k-space.

3. Method of claim 2, wherein at least a part of a central portion (30) of k-space is covered by each k-space subset (21-29).

4. Method of claim 2 or 3, wherein motion-induced displacements and/or phase errors are estimated and corrected in the k-space subsets (21-29) prior to reconstructing the MR image.

5. Method of claim 4, wherein motion of the object (10) is detected between the shots of the multi-echo imaging sequence.

6. Method of any one of claims 2-5, wherein each k-space subset (21-29) comprises a number of substantially parallel k-space profiles (31), wherein the k-space subsets (21-29) are rotated about the center of k-space, so that the total acquired set of echo signals spans a circle in k-space, wherein a common central circular region (30) of k-space is covered by all k-space subsets (21-29).

7. Method of any one of claims 2-6, wherein each k-space subset (21-29) is acquired by a single shot of the multi-echo imaging sequence.

8. Method of claim 7, wherein the respective portion of k-space is scanned two or more times within one shot of the multi-echo imaging sequence for each k-space subset (21-29), such that each k-space profile (31) of the respective k-space subset (21-29) is acquired at two or more different echo times.

9. Method of any one of claims 1-8, wherein the multi-echo imaging sequence is a fast spin echo sequence comprising

   - at least one RF pulse for excitation of magnetic resonance,
   - a plurality of refocusing RF pulses,
   - a plurality of switched magnetic field gradients for frequency-encoding of each echo signal, and
   - a plurality of switched magnetic field gradients for phase-encoding of each echo signal.

10. Method of any one of claims 1-9, wherein the derivation of the synthesized k-space profiles and the reconstruction of the MR image is repeated for two or more different target echo times.

11. MR device including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR device (1) is arranged to perform the following steps:

- subjecting the object (10) to a number of shots of a multi-echo imaging sequence, a train of echo signals being generated by each shot,
- acquiring the echo signals, each echo signal representing a k-space profile, wherein the echo signals are acquired two or more times for each k-space profile, each time at a different echo time;
- deriving synthesized k-space profiles from the acquired k-space profiles, wherein the synthesized k-space profiles are computed for a given target echo time by extrapolating or interpolating the echo signals acquired at the different echo times; and
- reconstructing a MR image from the synthesized k-space profiles.

12. Computer program to be run on a MR device, which computer program comprises instructions for:

- producing a number of shots of a multi-echo imaging sequence, a train of echo signals being generated by each shot,
- acquiring the echo signals, each echo signal representing a k-space profile, wherein the echo signals are acquired two or more times for each k-space profile, each time at a different echo time;
- deriving synthesized k-space profiles from the acquired k-space profiles (31), wherein the synthesized k-space profiles are computed for a given target echo time by extrapolating or interpolating the echo signals acquired at the different echo times; and
- reconstructing a MR image from the synthesized k-space profiles.

**Fig. 1**

**Fig. 2**

Europäisches
Patentamt

European
Patent Office

Office européen
des brevets

## EUROPEAN SEARCH REPORT

Application Number

EP 15 20 1917

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 684 891 A (FEINBERG DAVID A [US]) 4 August 1987 (1987-08-04) | 1-5,7-12 | INV. G01R33/48 |
| A | * column 10, line 10 - line 59; figure 6 * * column 12, line 19 - line 57 * | 6 | G01R33/561 G01R33/565 |
| A | XIAOHONG ZHOU ET AL: "Reduction of ringing and blurring artifacts in fast spin-echo imaging", JOURNAL OF MAGNETIC RESONANCE IMAGING, vol. 3, no. 5, 1 September 1993 (1993-09-01), pages 803-807, XP055266040, US ISSN: 1053-1807, DOI: 10.1002/jmri.1880030518 * the whole document * | 4 | |
| A | NORRIS D G ET AL: "ONLINE MOTION CORRECTION FOR DIFFUSION-WEIGHTED IMAGING USING NAVIGATOR ECHOES: APPLICATION TO RARE IMAGING WITHOUT SENSITIVITY LOSS", MAGNETIC RESONANCE IN MEDICINE, JOHN WILEY & SONS, INC, US, vol. 45, no. 5, 1 May 2001 (2001-05-01), pages 729-733, XP001011071, ISSN: 0740-3194, DOI: 10.1002/MRM.1099 * the whole document * | 4,5 | TECHNICAL FIELDS SEARCHED (IPC) G01R |
| A | US 2012/049846 A1 (GROSS PATRICK [DE] ET AL) 1 March 2012 (2012-03-01) * figure 6 * | 1-12 | |

-/--

The present search report has been drawn up for all claims

| Place of search | Date of completion of the search | Examiner |
|---|---|---|
| Munich | 25 May 2016 | Raguin, Guy |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | PIPE J G: "Motion correction with PROPELLER MRI: application to head motion and free-breathing cardiac imaging", MAGNETIC RESONANCE IN MEDICINE, JOHN WILEY & SONS, INC, US, vol. 42, no. 5, 1 November 1999 (1999-11-01), pages 963-969, XP002207261, ISSN: 0740-3194, DOI: 10.1002/(SICI)1522-2594(199911)42:5<963::AID-MRM17>3.0.CO;2-L * the whole document * | 1-12 | |
| A | US 2011/280456 A1 (SUSSMAN MARSHALL [CA] ET AL) 17 November 2011 (2011-11-17) * the whole document * | 1-5,7-12 | |
| A | WO 2008/135879 A1 (KONINKL PHILIPS ELECTRONICS NV [NL]; PHILIPS INTELLECTUAL PROPERTY [DE) 13 November 2008 (2008-11-13) * the whole document * | 1-5,7-12 | |
| A | US 2008/139919 A1 (KANNENGIESSER STEPHAN [DE] ET AL) 12 June 2008 (2008-06-12) * the whole document * | 1-5,7-12 | TECHNICAL FIELDS SEARCHED (IPC) |
| A | US 4 881 033 A (DENISON KENNETH S [US] ET AL) 14 November 1989 (1989-11-14) * the whole document * | 1-5,7-12 | |

The present search report has been drawn up for all claims

| Place of search | Date of completion of the search | Examiner |
|---|---|---|
| Munich | 25 May 2016 | Raguin, Guy |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 15 20 1917

This annex lists the patent family members relating to the patent documents cited in the above-mentioned European search report.
The members are as contained in the European Patent Office EDP file on
The European Patent Office is in no way liable for these particulars which are merely given for the purpose of information.

25-05-2016

| Patent document cited in search report | | Publication date | Patent family member(s) | Publication date |
|---|---|---|---|---|
| US 4684891 | A | 04-08-1987 | NONE | |
| US 2012049846 | A1 | 01-03-2012 | DE 102010039693 A1<br>US 2012049846 A1 | 01-03-2012<br>01-03-2012 |
| US 2011280456 | A1 | 17-11-2011 | NONE | |
| WO 2008135879 | A1 | 13-11-2008 | NONE | |
| US 2008139919 | A1 | 12-06-2008 | CN 101082659 A<br>DE 102006024976 B3<br>US 2008139919 A1 | 05-12-2007<br>31-10-2007<br>12-06-2008 |
| US 4881033 | A | 14-11-1989 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JAMES G. PIPE.** Motion Correction With PROPEL-LER MRI: Application to Head Motion and Free-Breathing Cardiac Imaging. *Magnetic Resonance in Medicine,* 1999, vol. 42, 963-969